Europäisches Patentamt

European Patent Office

Office européen des brevets

(11) Publication number: **0 226 154**
A2

(12) **EUROPEAN PATENT APPLICATION**

(21) Application number: 86117002.5

(22) Date of filing: 06.12.86

(51) Int. Cl.⁴: **H 03 H 11/20**
**H 03 H 11/28**

(30) Priority: 20.12.85 US 811589

(43) Date of publication of application:
24.06.87 Bulletin 87/26

(84) Designated Contracting States:
DE FR GB IT

(71) Applicant: ALLIED CORPORATION
Columbia Road and Park Avenue P.O. Box 2245R (Law Dept.)
Morristown New Jersey 07960(US)

(72) Inventor: Reif, Warren Paul C/o Allied Corporation
P.O. Box 5060 20650 Civic Center Drive
Southfield Michigan 48086(US)

(72) Inventor: Fathimulla, Mohammed Ayub C/o Allied Corporation
P.O. Box 5060 20650 Civic Center Drive
Southfield Michigan 48086(US)

(74) Representative: Brullé, Jean et al,
Service Brevets Bendix 44, rue François 1er
F-75008 Paris(FR)

(54) Monolithic dual-gate GaAs fet digital phase shifter with gain.

(57) A digitally controlled phase shifting circuit (8) which provides high gain and high output isolation by employing either a pair of dual-gate FETs (50,55) as an output circuit element or a split source, common drain dual-gate FET (95) as an output element.

EP 0 226 154 A2

# MONOLITHIC DUAL-GATE GaAs FET DIGITAL
# PHASE SHIFTER WITH GAIN

## 1. Field of the Invention

The present invention is directed to a digitally controlled phase shifting circuit, and more particularly to a digitally controlled phase shifting circuit having an amplifier output section.

## 2. Description of the Related Art

Most simply, a digitally controlled phase shifting circuit can comprise two delay lines of unequal lengths, an input switch for applying an input signal to either one of the delay lines, and an output switch for connecting an output terminal to either one of the delay lines. The switches of such an apparatus typically have a signal loss in the range of, for example, 1db. This simple phase shifter therefore has a loss of 2db.

An alternative phase shifting circuit is disclosed in Vorhaus et al., "Monolithic Dual-Gate GaAs FET Digital Phase Shifter," IEEE Trans. Microwave Theory Tech., Vol. MTI-30, No. 7, pp. 982-992, July 1982. This alternative circuit replaces the input switch with a split drain dual gate FET; and replaces the output switch with a Wilkinson three-port coupler. In this circuit, the input transistor has approximately 6db of gain, but the Wilkinson three-port coupler has approximately 3db of loss which reduces the overall gain of the phase shifter.

When employing a phase shifter as a circuit component, it is desirable to have the delay lines electrically isolated from the output. However, isolation achievable with a Wilkinson three-port coupler is approximately 25 db. At high frequencies, for example, above 12 GHz, the transmission lines of the Wilkinson three-port coupler begin to couple, and isolating thus decreases. Moreover, at low frequencies such as in the range of 5GHz, the transmission line of the Wilkinson three-port coupler become quite long;

thus, requiring a large percentage of the chip area occupied by the circuit employing the phase shifter.

## SUMMARY OF THE INVENTION

Accordingly, it is an object of the present invention to provide a digitally controlled phase shifter having high gain.

Another object of the present invention is provide a digitally controlled phase shifter having good isolation between the output of the phase shifter and the phase shifter delay elements.

A further object of the present invention is to provide a digitally controlled phase shifter structured to efficiently utilize chip area.

Still a further object of the present invention is to provide a digitally controlled phase shifter with gain and employing simple resistive matching circuits.

To achieve the above and other objects, the digitally controlled phase shifter of the present invention comprises a receiving means for receiving an input signal and for switching the input signal to provide first and second signals; a first delay means for providing a third signal corresponding to the first signal delayed by a first time delay; a second delay means for providing a fourth signal corresponding to the second signal delayed by a second time delay; and combining means for combining and amplifying the third and fourth signals to provide an output signal.

In a preferred embodiment of the digitally controlled phase shifter of the present invention, the receiving means comprises a split source, split drain, dual-gate FET, having an input signal applied to one of the gates. The first and second delay means can comprise delay lines of unequal lengths; low and high pass filters; or, for example, different band pass filters. The choice depends upon the desired amount of phase shift and the operating frequency of the digitally controlled phase shifter. The combining means can comprise either a pair of dual-gate FET's or a common drain, split source dual-gate FET.

The combining means comprising either a pair of dual-gate FET's or a common drain, split source dual-gate FET offers the advantages of good isolation between the output of the phase shifter and the phase shifter delay elements, and a high gain phase shifter. The high gain enables matching circuits to be constructed of resistive elements, thus simplifying the matching circuit structure and minimizing the circuit area required for the phase shifter. Additionally, the present invention provides the advantage of a digitally controlled phase shifter having gain and occupying less chip area than phase shifters employing a Wilkinson three-port coupler. These and other advantages of the present invention will be more apparent when reading the specification together with the appended figures.

## BRIEF DESCRIPTION OF THE DRAWINGS

The accompanying drawings illustrate embodiments of the present invention, and together with the description serve to explain the principles of the invention. In the drawings like reference numerals identify similar elements.

Fig. 1 is a block diagram of a first embodiment of the digitally controlled phase shifter of the present invention;

Figs. 2A and 2B are schematic diagrams illustrating embodiments of the input and output matching circuits shown in Fig. 1;

Fig. 3 is a plan view of an embodiment of the input transistor and associated input and output matching circuits shown in Fig. 1; and

Fig. 4 is a plan view of a split source, common drain, dual-gate FET employable as an alternative to the output transistors shown in Fig. 1.

## DETAILED DESCRIPTION OF THE PREFERRED EMBODIMENTS

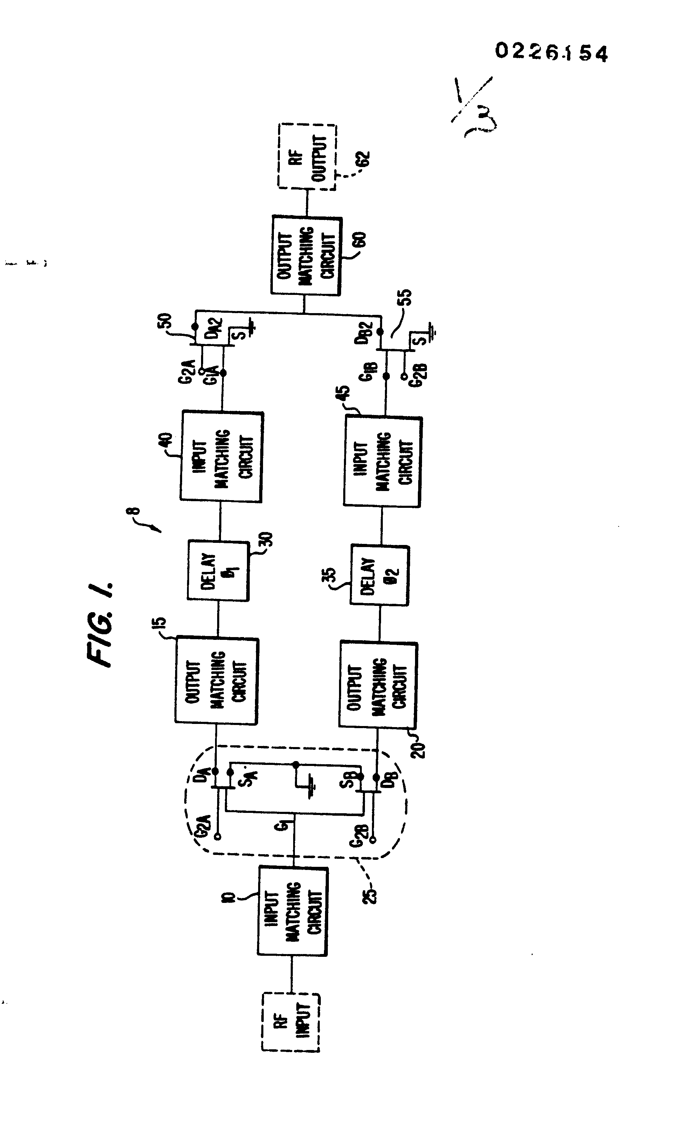

Fig. 1 is a block diagram of a first embodiment of the digitally controlled phase shifting circuit 8 of the present invention. In Fig. 1, reference numerals 10, 15 and 20 represent matching circuits for the split drain, dual-gate FET 25. The input matching circuit 10 ensures that the digitally controlled phase shifting circuit appears to have an input impedance equal to the impedance of a circuit providing an RF signal to the digitally controlled phase shifting circuit. The output matching circuits 15 and 20 respectively match the output impedance of a split drain, dual-gate FET 25 to the input impedances of delay elements 30 and 35. The input matching circuits 40 and 45 respectively match the output impedances of delay elements 30 and 35 with the input impedances of dual-gate FET's 50 and 55. Finally, an output matching circuit 60 ensures that the output impedance of the commonly connected drain of the FET's 50 and 55 matches the input impedance of a circuit to which the RF output 62 is applied.

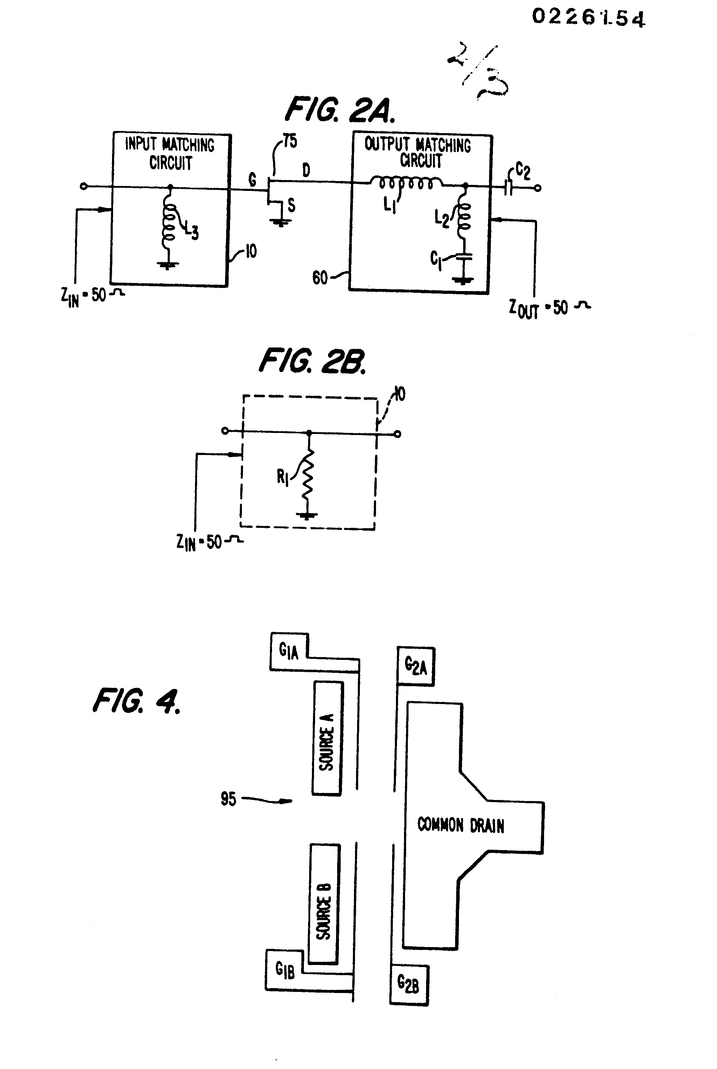

The function of the input and output matching circuits is known to those skilled in the art. Fig. 2A schematically illustrates an embodiment of input matching circuit 10 and an output matching circuit 60 for an FET 75. The embodiment of the Fig. 1 input matching circuit 10 as illistrated in Fig. 2A represents a simple shunt inductance $L_3$ to ground. A common input impedance desired for phase shifting circuits is 50 ohms; consequently, the impedance, $Z_{in}$ of the input matching circuits can be, for example 50 ohms or other typical values such as 75 ohms and 300 ohms. The impedance of input matching circuit 10 is not limited to these values, and, as is well known to those skilled in the art, is designed to match the output impedance of a ~ircuit supplying an RF signal to the FET 75 shown in Fig. 2A; or in the digitally controlled phase shifting circuit of the present invention, a circuit providing an RF signal to the split drain, dual-gate FET 25 shown in Fig. 1.

The embodiment of the output matching circuit 60 shown in Fig. 2A comprises a series/shunt LC matching circuit including series inductor $L_1$, shunt inductor $L_2$ and blocking capacitor $C_1$.

Fig. 2B is a schematic circuit diagram of an alternative embodiment of the input matching circuit 10. A resistive matching circuit such as shown in Fig. 2B can effectively be used with the digitally controlled phase shifting circuit 8 of the present invention. This is because the high gain of the present invention compensates for the attenuation of resistive matching circuits; resulting in a phase shifter with ample gain. The matching circuit shown in Fig. 2B can also be employed as the output matching circuits 15, 20, and 60 shown in Fig. 1. As will be recognized by those skilled in the art, as an RF input signal frequency increases, small value inductor and/or capacitors may be used in addition to the resistor R1 shown in Fig. 2B.

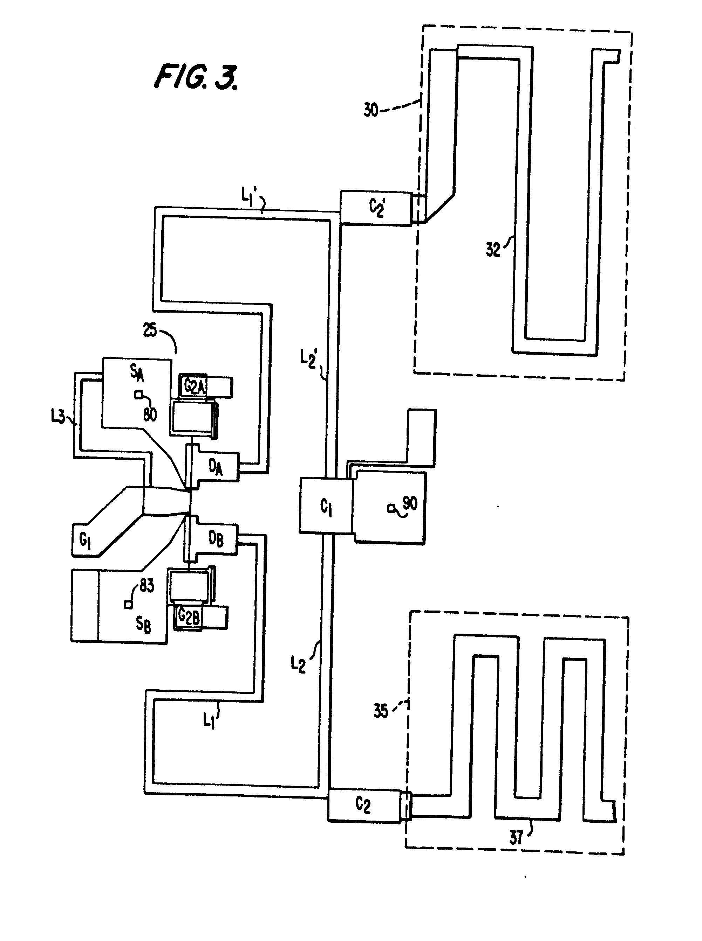

Fig. 3 is a plan view of an embodiment of the input matching circuit 10, the split drain, dual-gate FET 25 and output matching circuits 15 and 20 shown in Fig. 1. The elements corresponding to those shown in Fig. 2 are similarly labelled. The functions of the two paths supplied by transistor 25 are similar. Therefore, similar circuit elements in each path are identified with similar reference symbols. For example, the series inductances $L_1$ functions in a manner similar to the series inductance $L_1'$; and shunt inductance $L_2$ functions in a manner similar to the shunt inductance $L_2'$.

Referring to Fig. 3, the split sources $s_A$ and $S_B$ are respectively coupled to ground through feed throughs 80 and 83. The RF input input signal is applied to gate G1 which in turn is coupled to ground through L3 and source $S_A$. The inductance L3 functions as the input matching circuit 10 shown in Fig. 1. To switch the RF signal to drain $D_A$, the control gates $G_{2A}$ and $G_{2B}$ are respectively biased at 1.5 volts and -5 volts. To switch the RF input signal to drain $D_B$, the bias voltages are reversed so that 1.5 volts is applied to gate $G_{2B}$ and -5 volts is applied to gate $G_{2A}$.

Because the output paths from the split drains $D_A$ and $D_B$ are similar, only the path from drain $D_B$ is discussed. A signal provided by drain $D_B$ passes through the series inductor $L_1$ (Figs. 2 and 3) of the output matching circuit 60 to coupling capacitor $C_2$. The signal is also shunted to ground through inductance $L_2$ capacitor $C_1$ via feed through 90.

The delay elements 30 and 35 shown in Fig. 1 can comprise delay lines 32 and 37 of different lengths such as illustrated in Fig. 3. Alternatively, the desired phase shift can be created by employing various types of filters in place of the delay lines. For example, the delay element 35 can comprise a low pass filter while the delay element 30 can comprise a high pass filter. With this arrangement phase shifting is realized by switching the RF input signal between the low pass filter and the high pass filter. Alternatively, the delay elements 30 and 35 can comprise different bandpass filters, each having a different phase response, and ideally the same amplitude response; phase shifting with these elements is achieved by switching the RF input signal between the two bandpass filters. The choice of employing delay elements comprising simple delay lines 32 and 37, or filters is important as the desired amount of phase shift increases to, for example, 90° and 180°. This is because achieving such large phase shifts using simple delay lines 32 and 37 requires very long delay lines. As a result, the area occupied by the phase shifter is large, and the operating bandwidth of the digitally controlled phase shifting circuit is reduced due to larger phase error as the frequency varies from the phase shifter bandwidth center frequency. For example, the absolute value of the phase error at the edge of the phase shifter bandwidth for a 180° phase shifter is approximately four times that of a 22.5° phase shifter. Accordingly, to obtain large phase shifts, it is preferable to employ filters as delay elements 30 and 35. The choice depends upon the desired phase shift versus operating frequency of the digitally controlled phase shifting circuit, as well as the amount of chip area available for the phase shifter.

Referring to Fig. 1, the dual-gate FETs 50 and 55 provide approximately 2db to 3db of gain. Since the input FET 25 provides a net gain of approximately 6db, the digitally controlled phase shifting circuit of the present invention provides an overall gain in the range of 8db to 9db. A significant advantage of a digitally controlled phase shifting circuit providing a large gain such as this is that at low frequencies (in the range of 5 GHz), the input and output matching circuits 10, 15, 20, 40, 45 and 60 need not be LC circuits. Instead, these matching circuits can comprise resistive elements. Use of resistive elements significantly reduces the chip area occupied by the matching circuits. A typical resistive input matching circuit 10 is shown in Fig. 2B and comprises a shunt resistor R1. Use of resistive elements, however, reduces the gain of the phase shifter. But at low frequencies the gain of the overall phase shifter is still in the range of, for example, 4db to 6db.

The phase shifted RF signal is amplified through either dual-gate FET 50 or dual-gate FET 55 in accordance with bias voltages applied to the control gate $G_{2A}$ and $G_{2B}$. In the manner similar to the biasing discussed with respect to the switching through the split drain, dual-gate FET 25, if 1.5 volts is applied to gate $G_{2A}$ and -5 volts is applied to gate $g_{2B}$, then the RF signal is amplified through FET 50. Conversely, if -5 volts is applied to control gate $G_{2A}$, and 1.5 volts is applied to control gate $G_{2B}$, then the RF signal is amplified through FET 55. The FETs 50 and 55 provide good isolation between the input matching circuits 40 and 45 and the RF output, in the range of at least 35db.

Fig. 4 is a plan view of a split source, common drain, dual gate FET 95 employable as an alternative to the output transistors 50 and 55 shown in Fig. 1. When employing the FET 95, shown in Fig. 4, in the Fig. 1 digital phase shifting circuit 8, gate $G_{1A}$ of FET 95 is connected to the output of the input matching circuit 40, and gate $G_{1B}$ is connected to the output of the input matching circuit 45. The biasing control gates $G_{2A}$ and $G_{2B}$ are biased as are gates $G_{2A}$ and $G_{2B}$ of FETs 50 and 55 to switch phase of the RF signal.

The advantages of FET 95 over FETs 50 and 55 is that the FET 95 occupies less chip area, and the electrical characteristics of the switching paths between source A and source B to the common drain are more closely matched than are the electrical characteristics of FETs 50 and 55. FET 95 also provides good isolation between the input matching circuits 40 and 45 and the RF output, in the range of at least 35db.

The manufacturing techniques employed to produce a digitally controlled phase shifting circuit according to the present invention are within the knowledge of those skilled in the art. Accordingly, only a brief description of a method for fabricating a dual-gate FET employed in the present invention is discussed herein. Typically, fabrication of a dual-gate FET begins by doping a GaAs substrate with an impurity. For illustration purposes an n-channel device is discussed. A semi-insulating GaAs substrate with a dielectric constant of approximately 12.8 is doped to a concentration of approximately $2 \times 10^{17} cm^{-3}$, and to a depth of approximately 0.2 microns. This doped area comprises an active layer. Alternatively, the active layer can comprise an epi layer grown by MO-CVD, MBE or VPE. After formation of the active layer, portions of the active layer are selectively etched away to form mesas and source and drain contacts are formed on the mesas. Next, either dual-gates are formed on the mesas and adjacent to the gates, the source and drain contacts are formed; or source and drain contacts are formed on the mesas and then between the source and drain contacts, dual gates are formed. In addition, an $n^+$ region can be formed under the source and drain contact. Ohmic contacts to the n-type mesas are formed using, for example, AuGeNi electrodes.

The advantages of the digitally controlled phase shifting circuit of the present invention include:

1. A high gain phase shifting circuit enabling simpler and smaller resistive matching circuits to be employed.

2. High isolation between the delay lines and the output of the output matching circuit, in the range of at least 35 db resulting from the use of dual-gate FETs to amplify and provide the phase shifted RF signal to an output terminal.

3. A digitally controlled phase shifting circuit occupying reduced chip area due to use of dual-gate FET output circuit elements which provide gain, rather than a Wilkinson three-port coupler which occupies a large amount of area at low frequencies, and has 3db of loss.

It will be apparent to those skilled in the art that modifications and variations could be made in the digitally controlled phase shifting circuit of the present invention. Thus, the present invention is not limited to the embodiments described above, and is instead limited only by the scope of the appended claims and their equivalents.

-10-

## CLAIMS

1. A digitally controlled phase shifting circuit characterized by:

receiving means (25) for receiving an input signal and for switching the input signal to provide first and second signals;

first delay means (35), operatively connected to receive the first signal, for providing a third signal corresponding to the first signal delayed by a first time delay;

second delay means (35), operatively connected to receive the second signal, for providing a fourth signal corresponding to the second signal delayed by a second time delay; and

switching means (50,55), operatively connected to said first delay means and to said second delay means, for selectively switching and amplifying one of the third signal and the fourth signal, and for providing an amplified signal.

2. A digitally controlled phase shifting circuit according to claim 1 further characterized by said receiving means (25) including a split drain, dual-gate FET (25), having a first gate operatively connected to receive the input signal, sources operatively connected to ground, and first and second drains $(D_A, D_B)$ for providing the first and second signals.

3. A digitally controlled phase shifting circuit according to claim 2 further characterized by said switching (50,55) means including first and second dual-gate FETs (50,55),

said first dual-gate FET(50)having a first gate $(G_{1A})$ operatively connected to receive the third signal, a source operatively connected to ground and drain $(D_{A2})$ for providing an amplified third signal;

said second dual-gate FET (55) having a gate $(G_{1B})$ operatively connected to receive the fourth signal, a source operatively connected to ground and drain $(D_{B2})$

for providing an amplified fourth signal.

4. A digitally controlled phase shifting circuit according to claim 3, further characterized by said first dual-gate FET (50) having a second gate ($G_{2B}$) operatively connected to receive a first bias signal, and said second dual-gate FET (55) having a second gate ($G_{2B}$) operatively connected to receive a second bias signal.

5. A digitally controlled phase shifting circuit according to claim 4, further characterized by

first and second output matching circuit means (15,20) respectively connected between the first and second drains ($D_A$,$D_B$) of said split drain, dual gate FET (25) and said first and second delay means (30,35) for matching an output impedance of said split drain, dual-gate FET with an input impedance of said first delay means (30) and an input impedance of said second delay means (35);

first input matching means (10) operatively connected to receive the input signal and to the first gate ($G_1$) of said split drain, dual-gate FET (25), for matching an input impedance of said split drain, dual-gate FET (25) to a first desired impedance;

second input matching means (40) connected between said first delay means (30) and the first gate ($G_{1A}$) of said first dual-gate FET (50) for matching an output impedance of said first delay means (30) with an input impedance of said first dual-gate FET (50);

third input matching circuit means connected between said second delay means (35) and said second gate ($G_{1B}$) of said second dual-gate FET (55) for matching an output impedance of said second delay means (35) with an input impedance of said second dual-gate FET (55)

third output matching circuit means (50) operatively connected to the drains ($D_{A2}$,$D_{B2}$) of said first and second dual-gate FETs (50,55) and to provide the amplified signal, for matching output impedances of said first and second dual-gate FETs (50,55) to a second desired impedance.

6. A digitally controlled phase shifting circuit according to claim 4 further characterized by said first and second delay means respectively including first and second delay lines of different lengths respectively.

7. A digitally controlled phase shifting circuit according to claim 4 further characterized by said first delay means including a low pass filter and said second delay means including high pass filter.

8. A digitally controlled phase shifting circuit according to claim 2 further characterized by said switching means (50,55) including:

a split source, common drain dual-gate FET (95) including first and second sources operatively connected to ground, a first gate ($G_{1A}$) operatively connected to receive the third signal, a second gate ($G_{1B}$) operatively connected to receive the fourth signal, a third gate ($G_{2B}$) operatively connected to receive a first bias signal, a fourth gate ($G_{2B}$) operatively connected to receive a second bias signal and common drain for providing the amplified signal.

9. A digitally controlled phase shifting circuit according to claim 8 further characterized by

first and second output matching circuit means (15,20) respectively connected between the first and second drains ($D_A$,$D_B$) of said split drain, dual-gate FET (25) and said first and second delay means (30,35) for matching an output impedance of said split drain, dual-gate FET with an input impedance of said first delay means (30) and an input impendance of said second delay means (35);

first input matching circuit means (10) operatively connected to receive the input signal and to the first gate ($G_1$) of said split drain, dual-gate FET (25), for matching an input impedance of said split drain, dual-gate FET (25) to a first desired impedance;

second input matching circuit means (40) connected between said first delay means (30) and the first gate ($G_{1A}$) of said split source, common drain dual-gate FET (95), for matching an output impedance of said first delay means (30) with an input impedance of said split source, common drain dual-gate FET (95); and

third input matching circuit means (45) connected between said second delay means (35) and the second gate ($G_{1B}$) of said split source, common drain dual-gate FET (95) for matching an output impedance of said second delay means (35) with an input impedance of said split source, common drain dual-gate FET (95); and

third output matching circuit means (60) operatively connected to the common drain of said split source, common drain dual-gate FET (95) and to provide the amplified signal, for matching an output impedance of said split source, common drain dual-gate FET (95) to a second desired impedance.

10. A digitally controlled phase shifting circuit according to claim 9 further characterized by said first, second and third input matching circuit means and said first, second and third output matching circuit means each including resistive elements.

FIG. I.

**FIG. 2A.**

**FIG. 2B.**

**FIG. 4.**

FIG. 3.